# EUROPÄISCHE PATENTSCHRIFT

(11) **EP 1 283 664 B1**
(45) Veröffentlichungstag und Bekanntmachung des Hinweises auf die Patenterteilung: **10.10.2012**
(21) Anmeldenummer: 02017419.9
(22) Anmeldetag: 02.08.2002
(51) Int. Cl.: H05K 3/36, B23K 1/005, H01R 43/02

(54) **System aus Flachleiter und Bauteil und Verfahren zur Verlöten von Flachleiter und Bauteil**
System consisting of flat conductor and component and process for soldering flat conductor and component
Système d'un conducteur plat et un composant et procédé de souder un conducteur plat et un composant

(30) Priorität: 06.08.2001 DE 10138583
(43) Veröffentlichungstag der Anmeldung: 12.02.2003
(73) Patentinhaber: Delphi Technologies, Inc., Troy, MI 48007 (US)
(72) Erfinder: Schmitz, Klaus Dieter, 42553 Velbert/Neviges (DE); Busch, Ehrenfried, 42899 Remscheid (DE)
(74) Vertreter: Denton, Michael John

(56) Entgegenhaltungen:
- GB-A- 2 175 149
- US-A- 3 501 831
- US-A- 5 133 495
- US-A- 5 699 610
- US-B1- 6 246 548
- PATENT ABSTRACTS OF JAPAN Bd. 1997, Nr. 08, 29. August 1997 (1997-08-29) & JP 9 092349 A (CASIO COMPUT CO LTD), 4. April 1997 (1997-04-04)
- PATENT ABSTRACTS OF JAPAN Bd. 0144, Nr. 11 (E-0973), 5. September 1990 (1990-09-05) & JP 2 155292 A (MATSUSHITA ELECTRIC IND CO LTD), 14. Juni 1990 (1990-06-14)
- PATENT ABSTRACTS OF JAPAN Bd. 0154, Nr. 90 (E-1144), 11. Dezember 1991 (1991-12-11) & JP 3 212989 A (MATSUSHITA ELECTRIC IND CO LTD), 18. September 1991 (1991-09-18)
- PATENT ABSTRACTS OF JAPAN Bd. 1998, Nr. 01, 30. Januar 1998 (1998-01-30) & JP 9 245856 A (TOYOTA MOTOR CORP), 19. September 1997 (1997-09-19)

## Beschreibung

Die vorliegende Erfindung betrifft ein System aus einem Flachleiter und einem Bauteil sowie ein Verfahren zum Verlöten eines Flachleiters an einem Kontaktbereich eines Bauteils.

Flexible Flachleiter, insbesondere FPC-Flachleiter (flexible printed circuits) oder FFC-Flachleiter (flexible flat circuits), weisen eine Trägerfolie auf, die eine oder mehrere Schichten eines polymeren Materials enthält und in bzw. auf der Leiterbahnen angeordnet sind.

Beim Einsatz solcher Flachleiter ist es notwendig die Leiterbahnen mit Kontaktbereichen von anderen Bauteilen zu verbinden. Gängige flexible Flachleiter sind bisher jedoch allenfalls unter sehr hohem Aufwand über Lötverbindungen mit einem Kontaktbereich an einem anderen Bauteil verbindbar. Zum einen muß zwischen einem Kontaktbereich auf dem Flachleiter und dem Kontaktbereich auf dem anderen Bauteil auf komplizierte Weise Lot eingebracht werden. Zum anderen muß die zum Schmelzen des Lots notwendige Wärme durch die Trägerfolie des Flachleiters mittels eines Heißstempels oder anderen Lötwerkzeugen übertragen werden. Da die Trägerfolien schlechte Wärmeleiter sind bedarf es zum Erreichend des eutektischen Punktes eines Standardlots, der bei Temperaturen von mindestens 183° C liegt, einer Heißstempeltemperatur von über 260° C, die bis zum Schmelzen des Lots aufrechterhalten werden muß. Diese hohen Temperaturen führen in der Regel zur Verformung oder gar zur Zersetzung der Trägerfolie des Flachleiters. Aus diesem Grund wurden bisher zur elektrischen Verbindung von Flachleitern mit elektrischen Bauteilen kaum Lötverbindungen eingesetzt.

Die US 5 699 610 A offenbart ein elektrisches Substrat mit einem Kontaktbereich, der mit einem Lotdepot versehen wird und der zur Verbindung des Substrats mit einer flexiblen Schaltung ausgebildet ist. Die flexible Schaltung umfasst Durchgangslöcher, die elektrisch leitend beschichtet sind und zum Verlöten der Kontaktbereiche mit den an die Durchgangslöcher angrenzenden Teilen der flexiblen Schaltung dienen. Ferner ist ein Unterstützungselement vorgesehen, das mit dem Substrat verbunden wird und an dem die flexible Schaltung aufgehängt wird.

Die US 3 501 831 A offenbart eine flexible Schaltung mit einem auf einer Seite der Schaltung angeordneten Kontaktbereich, der sich an einen Leiter der Schaltung anschließt. Es wird vorgeschlagen, im Kontaktbereich ein Durchgangsloch durch die Schaltung zu stoßen und dabei gleichzeitig das verbleibende Leitermaterial so in Durchstoßrichtung zu drängen, dass das das Loch umgebende Material des Kontaktbereichs auf der dem Kontaktbereich abgewandten Seite der Schaltung nach außen vorsteht.

Es ist Aufgabe der Erfindung, ein verbessertes System aus einem Flachleiter und einem Bauteil sowie ein verbessertes Verfahren zum Verlöten eines Flachleiters mit einem Kontaktbereich eines Bauteils bereitzustellen.

Die Aufgabe wird gelöst durch ein System mit den Merkmalen des Anspruchs 1 und ein Verfahren nach Anspruch 5.

Der Flachleiter des Systems, bei dem es sich insbesondere um einen flexiblen Flachleiter, z.B. einen FPC- oder FFC-Flachleiter, handeln kann, hat einen zu einer seiner Flachseiten hin aufgebogenen Randbereich, der auf der gegenüberliegenden Seite einen lötbaren, elektrisch leitenden und mit mindestens einer Leiterbahn des Flachleiters verbundenen Kontaktbereich aufweist.

Die Aufbiegung, die z.B. durch Prägen herstellbar ist, ist dabei so ausgebildet, daß bei einer späteren Lötung eine gute Benetzung durch flüssiges Lot möglich ist. Der Kontaktbereich kann sich dabei bis in einen ebenen Teil des Flachleiters fortsetzen.

Der Flachleiter ist mit dessen Kontaktbereich an einem Kontaktbereich eines elektrischen oder elektronischen Bauteils mittels des erfindungsgemäßen Verfahrens verlötbar, bei dem die Kontaktbereiche des Flachleiters und des Bauteils so positioniert werden, daß sich der aufgebogene Randbereich gegenüber dem Kontaktbereich des Bauteils befindet und von diesem wegweist, und bei dem mittels einer Wärmequelle flüssiges Lot erzeugt wird, durch das die Kontaktbereiche auf Löttemperatur gebracht werden. Nach Abkühlung des Lots wenigstens bis zur Erstarrung, sind dann die Kontaktbereiche durch das erstarrte Lot elektrisch und mechanisch miteinander verbunden. Hierbei können der den aufgebogenen Randbereich aufweisende Teil des Flachleiters und ein den Kontaktbereich tragender Abschnitt des elektrischen oder elektronischen Bauteils wenigstens teilweise aufeinander aufliegen.

Durch diese Positionierung des Flachleiters an bzw. auf dem Kontaktbereich des Bauteils ist zum einen der Raum zwischen dem Kontaktbereich des aufgebogenen Randbereichs und dem Kontaktbereich des Bauteils zur Bereitstellung des flüssigen Lots zugänglich. Zum anderen wird durch die unmittelbare Erhitzung des Lots, das wiederum die Kontaktbereiche erhitzt, eine Wärmeübertragung über den Träger des Flachleiters und eine damit einhergehende Beschädigung des Trägers vermieden. Dieses Verfahren wird insbesondere dadurch begünstigt, daß der Träger des Flachleiters nur eine geringe Wärmeleitfähigkeit hat und der in der Regel nur sehr flach und schmal ausgebildete Kontaktbereich auf dem Flachleiter nur sehr wenig Wärme aufnehmen bzw. weiterleiten kann, so daß er sehr schnell durch das flüssige Lot auf Löttemperatur gebracht werden kann.

Durch die Erfindung wird es somit ermöglicht, Kontaktbereiche von Flachleitern an Kontaktbereiche anderer Bauteile zu löten, wodurch eine sehr sichere Verbindung mit sehr geringem Übergangswiderstand gewährleistet ist. Darüber hinaus kann eine solche Lötverbindung erhebliche Zug- und Scherkräfte aufnehmen, wodurch die Anforderung im Hinblick auf eine Zugentlastung deutlich reduziert werden.

Weiterbildungen und bevorzugte Ausführungsformen der Erfindung sind in den Ansprüchen, in der Beschreibung und in der Zeichnung beschrieben.

Bevorzugt ist der Randbereich um nicht mehr als 90° aufgebogen, wodurch eine gute Benetzung durch das flüssige Lot gewährleistet wird. In einem Schnitt senkrecht zur Ebene des Flachleiters betrachtet, kann der Randbereich im wesentlichen geradlinig verlaufen, wobei er gegenüber dem ebenen Teil des Flachleiters abgeknickt ist. Besonders bevorzugt kann die Aufbiegung jedoch auch in einer konkaven Wölbung nach oben bestehen, wobei auch hier der Randbereich zu seinem Ende hin geradeaus laufen kann. Eine solche Aufbiegung kann nicht nur einfacher, sondern auch unter geringerer Materialermüdung, z.B. durch Prägung, hergestellt werden. Darüber hinaus kann sich ein besseres Verlaufen des flüssigen Lots bzw. eine bessere Benetzung der beiden Kontaktbereiche ermöglichen.

Der aufgebogene Randbereich ist durch einen wenigstens teilweise um eine Öffnung in dem Flachleiter verlaufenden Kragen gebildet. Ein solcher Randbereich kann besonders einfach hergestellt werden, da die Bildung der Öffnung und die Ausprägung des Kragens in einem Arbeitsschritt erfolgen kann. Darüber hinaus kann eine mit dem erfindungsgemäßen Verfahren hergestellte Lötverbindung an dem Flachleiter in mehreren Richtungen sehr gut Zug- und Scherkräfte aufnehmen, da auf den Träger wirkende Kräfte über größere Bereiche des Kragens auf die Lötverbindung und damit den Kontaktbereich des Bauelements übertragen werden können. Darüber hinaus wird bezogen auf die Fläche der Verbindung eine besonders große Lötfläche zur Verfügung gestellt, wodurch ein besonders geringer Übergangswiderstand erzielbar ist, der auch einen Einsatz zur Übertragung großer Ströme, wie sie z.B. im Automobilbereich notwendig sind, ermöglicht.

Die Öffnung ist im wesentlichen kreisförmig ausgebildet, sodass sie zum einen sehr einfach wegen ihrer Symmetrie herstellbar ist und zum anderen in allen Richtungen gleich gut Zug- und Scherkräfte aufnehmen kann.

Bei dem erfindungsgemäßen Verfahren wird das Lot in geeigneter Form auf dem Kontaktbereich eines elektrischen oder elektronischen Bauteils deponiert, um dann bei der Verlötung geschmolzen zu werden. Bestandteil des erfindungsgemäßen Systems ist daher auch ein elektrisches oder elektronisches Bauteil mit einem Kontaktbereich zur Verbindung mit einem Flachleiter, bei dem der Kontaktbereich des Bauteils ein Lotdepot aufweist, dessen Form wenigstens einen Bereich der Form des Raums zwischen dem aufgebogenen Randbereich des Flachleiters und dem auf dem von der Aufbiegung wegweisenden Seite an dem Flachleiter angeordneten Kontaktbereich des Bauteils entspricht. Zur Verlötung werden Flachleiter und Bauteil so positioniert, daß der aufgebogene Randbereich nahe eines Umfangsbereichs des Lotdepots verläuft. Das Lotdepot kann hierbei, je nach Formgebung, den aufgebogenen Randbereich berühren oder mit diesem einen schmalen Spalt bilden. Daraufhin wird das Lot in dem Lotdepot direkt durch eine Wärmequelle erhitzt, bis sich das Lot verflüssigt hat und die zu verbindenden Kontaktbereiche eine zur Herstellung der Lötung erforderliche Temperatur erreicht haben. Danach wird die Verbindung abgekühlt.

Durch die Verwendung des Bauteils mit einem Lotdepot auf dem Kontaktbereich wird eine Positionierung des Flachleiters relativ zu dem Bauteil erleichtert, da das Lotdepot als Positioniermittel dienen kann, das bei vorsichtiger Bewegung des Flachleiters und/oder des Bauteils als Anschlag für den aufgebogenen Randbereich des Flachleiters dient. Dieses Verfahren hat den Vorteil, daß sich das Lot schon zu Beginn des Verbindungsvorgangs am richtigen Ort befindet, wodurch Schwierigkeiten bei der Handhabung von festem oder flüssigen Lot vermieden werden. Insbesondere kann leichter gewährleistet werden, daß die zur Lötung verwendete Lotmenge nur in einem sehr geringen Bereich schwankt.

Das Lotdepot wird durch Aufdrucken von Lötpaste auf dem Kontaktbereich des Bauteils gebildet, was dadurch erleichtert wird, daß viele Lötpasten thixotropes Verhalten zeigen. Hierdurch ist eine besonders einfache und gleichzeitig präzise Herstellung der Lotdepots möglich, da Position und Form des Lotdepots wie auch die darin enthaltene Lotmenge genau gesteuert werden können.

Das Lotdepot ist kegelstumpfförmig ausgebildet, wobei besonders vorteilhaft der Kegelöffnungswinkel des Lotdepots der Neigung der Aufbiegung entspricht. Da das Lot an der Oberfläche aufgeschmolzen wird, wird hierdurch ein besonders günstiges Benetzungsverhalten erzielt.

Bevorzugt kann der Kontaktbereich des Bauteils auf einem Flachleiter ausgebildet sein, wodurch eine Lötverbindung zweier Flachleiter ermöglicht wird.

Der Kontaktbereich des Bauteils kann jedoch auch vorteilhaft durch einen Festleiter bzw. eine starren Leiter gebildet werden oder auf einer Leiterplatte ausgebildet sein, wodurch eine direkte Verbindung von Flachleiter und Festleiter bzw. Leiterplatte ohne aufwendige Stecker- oder Crimpverbindungen möglich ist.

Bevorzugt wird bei dem erfindungsgemäßen Verfahren zur Erzielung einer besseren Benetzung durch das flüssige Lot und zur Vermeidung sehr großer Temperaturgradienten der Kontaktbereich des Bauteils wenigstens nahe dem aufgebogenen Randbereich des Flachleiters vor dem Erhitzen des Lots auf eine Temperatur unterhalb der Löttemperatur erwärmt. Insbesondere wird hierdurch eine Lötverbindung an massiven Leitern ermöglicht, die anderenfalls bis zum Erreichen der Löttemperatur an den Kontaktflächen sehr große Wärmemengen aufnehmen oder abführen würden und so eine vergleichsweise lang andauernde Erwärmung des Lots und eine damit einhergehende Übertragung großer Wärmemengen auf den Träger des Flachleiters bedingen würden. Der Träger des Flachleiters würde durch diese lang andauernde Wärmezufuhr einer ungünstig hohen Wärmebelastung ausgesetzt. Darüber hinaus wird so eine gleichmäßige Erhitzung gewährleistet.

Weiterhin kann bevorzugt auch der Flachleiter im Bereich des aufgebogenen Randbereichs vor dem Erhitzen des Lots auf eine Temperatur unterhalb der Löttemperatur, und besonders bevorzugt unterhalb einer den Flachleiter schädigenden Temperatur, erwärmt werden. Auch hierdurch ergibt sich ein besseres Benetzungsverhalten des Lots. Schließlich wird eine gleichmäßigere Erhitzung des noch festen Lots erzielt.

Grundsätzlich kann das Lot mit bekannten Mitteln, insbesondere mittels eines Lötkolbens oder eines Heißstempels, erhitzt werden. Bevorzugt wird es jedoch berührungslos erhitzt, wozu unter anderem Laserstrahlen verwendet werden können. Besonders bevorzugt wird das Lot jedoch durch einen heißen Schutzgasstrom, vorzugsweise Stickstoff, erhitzt. Hierdurch kann die Verwendung aggressiver Flußmittel stark eingeschränkt werden.

Um einen Fluß des flüssigen Lots aus dem Randbereich heraus zu vermeiden und um die Kontaktbereiche stabil gegeneinander zu positionieren, werden bevorzugt nach dem Positionieren von Bauteil und Flachleiter die Kontaktbereiche des Bauteils und des Flachleiters gegeneinander gedrückt, was durch entsprechende Stempel geschehen kann, die darüber hinaus zur Erwärmung des Flachleiters bzw. des Kontaktbereichs des Bauteils ausgebildet sein können.

Erfindungsgemäß kann der aufgebogene Randbereich auch auf einem Festleiter ausgebildet sein. Zur Verbindung können dann die oben beschriebenen Verfahren und Leiter und Systeme analog verwendet werden.

Eine bevorzugte Ausführungsform der Erfindung wird nun beispielhaft anhand der Zeichnungen beschrieben. Es zeigen:
- Fig. 1: eine schematische Schnittansicht durch ein als Flachleiter ausgebildetes elektrisches Bauteil und einem darüber angeordneten Flachleiter nach einer bevorzugten Ausführungsform der Erfindung,
- Fig. 2: das Bauteil und den Flachleiter in Fig. 1, wobei das Bauteil in einer Draufsicht und der Flachleiter in einer schematischen Ansicht von unten gezeigt sind,
- Fig. 3: eine schematische Schnittansicht durch das Bauteil und den Flachleiter aus Fig. 1 in einer zusammengefügten Position vor dem Lötvorgang,
- Fig. 4: eine schematische Schnittansicht durch die Anordnung in Fig. 3 während des Lötvorgangs, und
- Fig. 5: eine schematische Schnittansicht durch das elektrische Bauteil und den Flachleiter in Fig. 4 nach Fertigstellung der Lötverbindung.

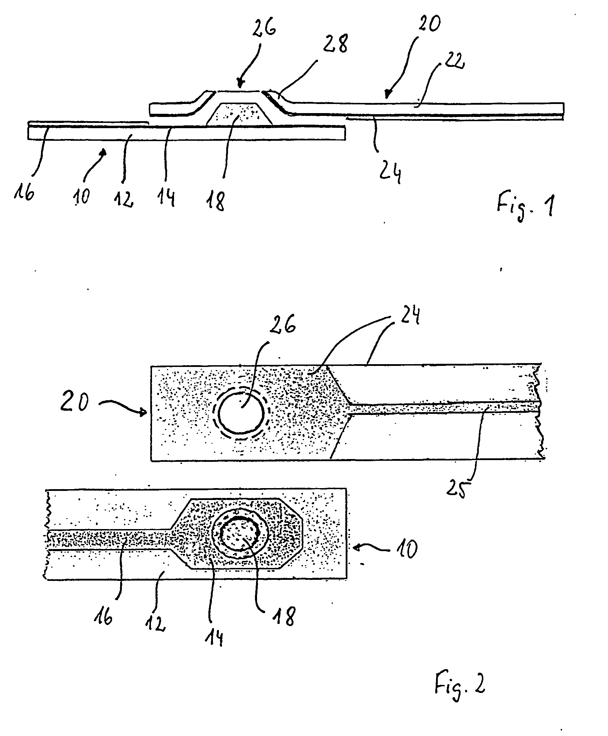

In den Fig. 1 und 2 ist ein elektrisches Bauteil 10 als ein erster FPC-Flachleiter ausgebildet, der einen mehrschichtigen Träger 12 und darauf ausgebildet einen Kontaktbereich 14 aus Kupfer aufweist. Der Kontaktbereich 14 ist mit einer durch mindestens eine Schicht des Trägers 12 abgedeckten Leiterbahn 16 verbunden, die an dem Kontaktbereich 14 aus dem Träger 12 heraustritt.

Auf dem Kontaktbereich 14 ist durch Aufdrucken von Lötpaste ein kegelstumpfförmiges Lotdepot 18 ausgebildet. Der Kegelwinkel des Kegelstumpfs beträgt etwa 46° und die Höhe des Kegelstumpfs relativ zu dem Durchmesser des Kegelstumpfs an seiner Basis etwa 0,25.

Ein zweiter FPC-Flachleiter 20 trägt auf einem Träger 22 einen sich in den Fig. 1 und 2 über die gesamte Fläche des Trägers 22 erstreckenden Kontaktbereich 24 aus Kupfer, der mit einer Leiterbahn 25 in dem Träger 22 verbunden ist. Der Flachleiter weist eine im wesentlichen kreisförmige Öffnung 26 auf, deren Randbereich 28 unter Ausbildung eines Kragens in einem Winkel von etwa 65° zu der Seite aufgebogen ist, die der den Kontaktbereich 24 tragenden Seite gegenüberliegt. Der Durchmesser der Öffnung 26 nahe der Aufbiegung ist um etwa 0,3 mm größer als der Durchmesser des Lotdepots an seiner Basis. Die Form des Lotdepots 18 entspricht dabei, wie in den Fig. 1, 3 und 4 erkennbar, der Form der Aufbiegung, wobei ein Spalt 29 zwischen den Kontaktbereichen 14 und 24 gebildet wird. Im Beispiel erstreckt sich der aufgebogene Randbereich 28 etwa soweit von dem Träger 22 weg, daß das Lotdepot 18 und der aufgebogenen Randbereich 28 etwa auf gleicher Höhe relativ zu dem Träger 22 enden.

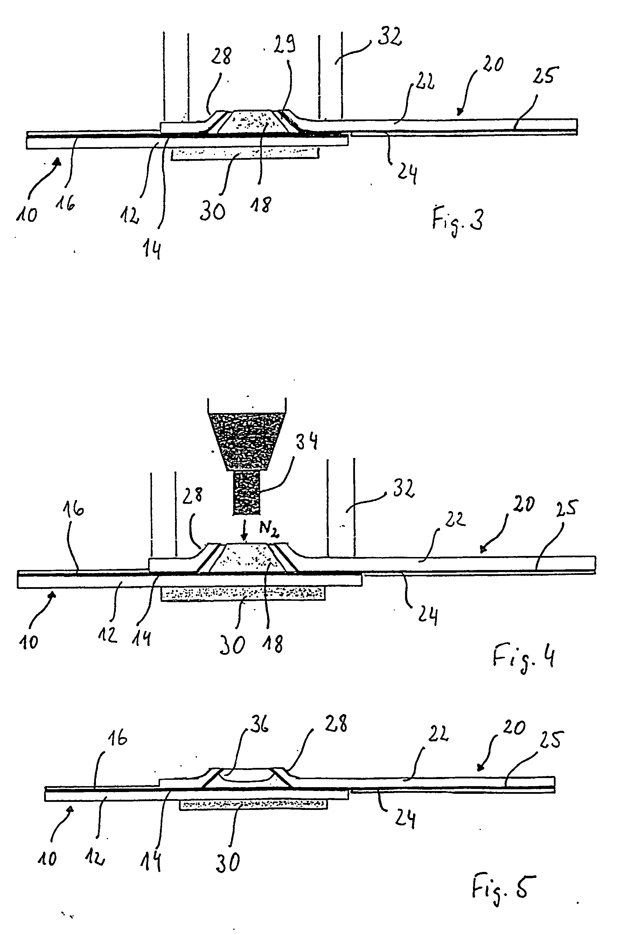

Zur Herstellung der Lötverbindung werden, wie in Fig. 3 gezeigt, auf einer beheizbaren Wärmeplatte 30 der erste Flachleiter 10 und darauf der zweite Flachleiter 20 so positioniert, daß das Lotdepot 18 von dem aufgebogenen Randbereich 28 des zweiten Flachleiters 20 umschlossen wird. Durch einen beheizbaren, zylinderförmigen Stempel 32 werden der erste Flachleiter 10 und der zweite Flachleiter 20 nahe dem aufgebogenen Randbereich 28 aufeinander gepreßt und damit gegeneinander fixiert.

Sowohl die Wärmeplatte 30 wie auch der zylinderförmige Stempel 32 werden erhitzt, um den ersten Flachleiter 10 und den zweiten Flachleiter 20 im Bereich der Lötung auf eine Temperatur von etwa 80° C, die unterhalb einer Schädigungstemperatur der Träger 12 und 22 der beiden Flachleiter 10 bzw. 20 liegt, vorzuwärmen. Hierdurch ergeben sich in den Trägern 12 und 22 in der Nähe der Kontaktbereiche 14 bzw. 24 und in dem Lotdepot 18 bei der späteren Lötung geringere Temperaturgradienten.

Wie in Fig. 4 gezeigt, wird daraufhin über eine Düse 34 heißer Stickstoff (N₂) von oben direkt auf das Lotdepot 18 gerichtet. Der Stickstoffstrahl weist dabei eine Temperatur von etwa 220° C auf und ist durch die Düse 34 auf das Lotdepot 18 fokussiert. Durch diese Zufuhr von Wärme schmilzt das Lot und benetzt die Kontaktbereiche 24 und 14 und bringt sie auf Löttemperatur. Nach einer gegebenenfalls durch Versuche zu optimierenden Zeit haben die Kontaktbereiche 14 und 24 die Löttemperatur erreicht, so daß der Stickstoffstrahl abgeschaltet oder die Düse 34 zu einer anderen Lötverbindung bewegt werden kann.

Daraufhin wird die Vorwärmung durch die Wärmeplatte 30 und den Stempel 32 abgeschaltet und der Flachleiter 20 noch für eine vorgegebenen Abkühlzeit von dem Stempel 32 auf dem ersten Flachleiter 10 gehalten, bis das Lot hinreichend weit erstarrt ist.

In Fig. 5 sind der erste Flachleiter 10 und der zweite Flachleiter 20 nach Herstellen der Lötverbindung gezeigt. Das Lot, das nach der Verflüssigung an dem Kontaktbereich 24 des aufgebogenen Randbereichs 28 aufgrund der Oberflächenspannung einen Meniskus 36 gebildet hat, ist in dieser Form erstarrt, und verbindet nun den Kontaktbereich 24 im Bereich des aufgebogenen Randbereichs 28 mit dem Kontaktbereich 14 auf dem ersten Flachleiter 10.

Aufgrund der Dimensionierung der Öffnung 26 und das aufgebogenen Randes 28 ragt der Bereich der Lötverbindung nur gering über den Flachleiter 20 hinaus.

### Bezugszeichenliste

- 10: erster Flachleiter
- 12: Träger
- 14: Kontaktbereich
- 16: Leiterbahn
- 18: Lotdepot
- 20: zweiter Flachleiter
- 22: Träger
- 24: Kontaktbereich
- 25: Leiterbahn
- 26: Öffnung
- 28: aufgebogener Randbereich
- 29: Spalt
- 30: Wärmeplatte
- 32: zylinderförmiger Stempel
- 34: Düse
- 36: Meniskus

## Patentansprüche

1. System umfassend
einen mit einer Lötverbindung zu verbindenden Flachleiter (20) mit einem zu einer Flachseite des Flachleiters hin aufgebogenen Randbereich (28), der auf der gegenüberliegenden Seite einen lötbaren, elektrisch leitenden und mit mindestens einer Leiterbahn (25) des Flachleiters (20) verbundenen Kontaktbereich (24) aufweist, wobei der aufgebogene Randbereich (28) durch einen Kragen (28) gebildet ist, welcher wenigstens teilweise um eine im wesentlichen kreisförmig ausgebildete Öffnung (26) in dem Flachleiter (20) verläuft, und
ein elektrisches oder elektronisches Bauteil (10) mit einem Kontaktbereich (14) zur Verbindung mit dem Flachleiter (20), wobei der Kontaktbereich (14) des Bauteils (10) ein im wesentlichen kegelstumpfförmig ausgebildetes Lotdepot (18) aufweist, dessen Form in wenigstens einem Bereich der Form des Raums zwischen dem aufgebogenen Randbereich (28) des Flachleiters (20) und dem auf der von der Aufbiegung wegweisenden Seite an dem Flachleiter (20) angeordneten Kontaktbereich (14) des Bauteils (10) entspricht.

2. Flachleiter nach Anspruch 1,
**dadurch gekennzeichnet,**
**daß** der aufgebogene Randbereich (28) um nicht mehr als 90° aufgebogen ist.

3. System nach Anspruch 1 oder 2,
**dadurch gekennzeichnet,**
**daß** der Kontaktbereich (14) des Bauteils (10) auf einem Flachleiter ausgebildet ist.

4. Bauteil nach Anspruch 1 oder 2,
**dadurch gekennzeichnet,**
**daß** der Kontaktbereich (14) des Bauteils (10) durch einen Festleiter gebildet oder auf einer Leiterplatte ausgebildet ist.

5. Verfahren zum Verlöten eines Flachleiters (20), welcher einen zu einer Flachseite des Flachleiters hin aufgebogenen Randbereich (28) umfasst und welcher auf der gegenüberliegenden Seite einen lötbaren, elektrisch leitenden und mit mindestens einer Leiterbahn (25) des Flachleiters (20) verbundenen Kontaktbereich (24) aufweist, wobei der Randbereich (28) durch einen Kragen (28) gebildet ist, der wenigstens teilweise um eine im wesentlichen kreisförmig ausgebildete Öffnung (26) in dem Flachleiter (20) verläuft, mit einem Kontaktbereich (14) eines elektrischen oder elektronischen Bauteils (10), wobei das Verfahren die Schritte aufweist:
Aufdrucken von Lötpaste auf den Kontaktbereich (14) des Bauteils (10) zur Bildung eines im wesentlichen kegelstumpfförmig ausgebildeten Lotdepots (18),
Positionieren der Kontaktbereiche (24, 14) des Flachleiters (20) und des Bauteils (10) so, daß sich der aufgebogene Randbereich (28) gegenüber dem Kontaktbereich (14) des Bauteils (10) befindet, von diesem wegweist und nahe eines Umfangsbereichs des Lotdepots (18) verläuft,
direktes Erhitzen des Lots in dem Lotdepot (18), bis das Lot sich verflüssigt hat und die zu verbindenden Kontaktbereiche (14, 24) eine zur Herstellung der Lötung erforderliche Temperatur erreicht haben, und
Abkühlen der Verbindung mindestens bis zur Erstarrung des Lots.

6. Verfahren nach Anspruch 5,
**dadurch gekennzeichnet,**
**daß** der Kontaktbereich (14) des Bauteils (10) wenigstens nahe dem aufgebogenen Randbereich (28) vor dem Erhitzen des Lots auf eine Temperatur unterhalb der Löttemperatur erwärmt wird.

7. Verfahren nach Anspruch 5 oder 6,
**dadurch gekennzeichnet,**
**daß** der Flachleiter (20) im Bereich des aufgebogenen Randbereichs (28) vor dem Erhitzen des Lots auf eine Temperatur unterhalb der Löttemperatur erwärmt wird.

8. Verfahren nach einem der Ansprüche 5 bis 7,
**dadurch gekennzeichnet,**
**daß** das Lot berührungslos erhitzt wird.

9. Verfahren nach einem der Ansprüche 5 bis 8,
**dadurch gekennzeichnet,**
**daß** das Erhitzen des Lots durch einen heißen Schutzgasstrom erfolgt.

10. Verfahren nach einem der Ansprüche 5 bis 9,
**dadurch gekennzeichnet,**
**daß** nach dem Positionieren der Kontaktbereich (14) des Bauteils (10) und der Flachleiter (20) gegeneinandergedrückt werden.

## Claims

1. System, comprising:
a flat conductor (20) for soldered connection, having an edge area (28) bent-up towards a flat side of the flat conductor, comprising, on the opposite side, a solderable electrically conductive contact area (24) connected to at least one conductor path (25) of the flat conductor (20), wherein the bent-up edge area (28) is formed by a collar (28) extending at least partially around a substantially circular opening (26) in the flat conductor (20), and
an electric or electronic component (10) with a contact area (14) for connection to the flat conductor (20), wherein the contact area (14) of the component (10) comprises a substantially conical solder deposit (18) whose form corresponds in at least one area to the form of the space between the bent-up edge area (28) of the flat conductor (20) and the contact area (14) of the component (10) disposed on the side of the flat conductor (20) directed away from the bent-up area.

2. Flat conductor according to claim 1,
**characterized in that**
the bent-up edge area (28) is bent by no more than 90°.

3. System according to claim 1 or 2,
**characterized in that**
the contact area (14) of the component (10) is formed on a flat conductor.

4. Component according to claim 1 or 2,
**characterized in that**
the contact area (14) of the component (10) is formed by a fixed conductor or is formed on a circuit board.

5. Method for soldering a flat conductor (20) having an edge area (28) bent-up towards a flat side of the flat conductor and comprising, on the opposite side, a solderable electrically conductive contact area (24) connected to at least one conductor path (25) of the flat conductor (20), wherein the edge area (28) is formed by a collar (28) extending at least partially around a substantially circular opening (26) in the flat conductor (20), to a contact area (14) of an electric or electronic component (10), wherein the method comprises the steps of:
imprinting of solder paste onto the contact area (14) of the component (10) for forming a substantially conical solder deposit (18),
positioning the contact areas (24, 14) of the flat conductor (20) and the component (10) such that the bent-up edge area (28) is opposite the contact area (14) of the component (10), directed away therefrom and extending in proximity to a circumferential area of the solder deposit (18),
directly heating of the solder in the solder deposit (18) until the solder becomes liquid and the contact areas (24, 14) to be connected reach a temperature required for soldering, and
cooling the connection at least up to the solidification of the solder.

6. Method according to claim 5,
**characterized in that**
the contact area (14) of the component (10) at least in proximity of the bent-up edge area (28) is heated to a temperature beneath the soldering temperature before heating the solder.

7. Method according to claim 5 or 6,
**characterized in that**
the flat conductor (20) in the bent-up edge area (28) is heated to a temperature beneath the soldering temperature before heating the solder.

8. Method according to one of claims 5 to 7,
**characterized in that**
the solder is heated without contact.

9. Method according to one of claims 5 to 8,
**characterized in that**
the heating of the solder is accomplished by a hot protective gas flow.

10. Method according to one of claims 5 to 9,
**characterized in that**
after the positioning the contact area (14) of the component (10) and the flat conductor (20) are pressed against each other.

## Revendications

1. Système comprenant
un conducteur plat (20) à relier avec une liaison brasée, comportant une zone de bordure (28) cintrée en direction d'un côté plat du conducteur plat, lequel comporte sur le côté opposé une zone de contact (24) à braser, conductrice de l'électricité et reliée à au moins une piste conductrice (25) du conducteur plat (20), dans lequel la zone de bordure cintrée (28) est formée par une collerette (28), laquelle s'étend au moins partiellement autour d'une ouverture (26) réalisée sensiblement sous forme circulaire dans le conducteur plat (20), et
un composant électrique ou électronique (10) avec une zone de contact (14) pour la liaison avec le conducteur plat (20), la zone de contact (14) du composant (10) comprenant un dépôt de brasure (18) réalisé sensiblement en forme de tronc de cône, dont la forme correspond dans au moins une zone à la forme de l'espace entre la zone de bordure cintrée (28) du conducteur plat (20) et la zone de contact (14), agencée contre le conducteur plat (20) sur le côté détourné du cintrage, du composant (10).

2. Conducteur plat selon la revendication 1,
**caractérisé en ce que** la zone de bordure cintrée (28) n'est pas cintrée sur plus de 90°.

3. Système selon la revendication 1 ou 2,
**caractérisé en ce que** la zone de contact (14) du composant (10) est réalisée sur un conducteur plat.

4. Système selon la revendication 1 ou 2,
**caractérisé en ce que** la zone de contact (14) du composant (10) est formée par un conducteur fixe ou est réalisée sur une carte à circuits imprimés.

5. Procédé pour braser un conducteur plat (20) qui comprend une zone de bordure (28) cintrée vers un côté plat du conducteur plat et qui comporte sur le côté opposé une zone de contact (24) à braser, conductrice de l'électricité et reliée à au moins une piste conductrice (25) du conducteur plat (20), dans lequel la zone de bordure (28) est formée par une collerette (28) qui s'étend au moins partiellement autour d'une ouverture (26) réalisée sensiblement sous forme circulaire dans le conducteur plat (20), avec une zone de contact (14) d'un composant électrique ou électronique (10), le procédé comprenant les étapes consistant à :
appliquer de la pâte de brasage sur la zone de contact (14) du composant (10) pour former un dépôt de brasure (18) réalisé sensiblement en forme de tronc de cône,
positionner les zones de contact (24, 14) du conducteur plat (20) et du composant (10) de telle manière que la zone de bordure cintrée (28) se trouve à l'opposé de la zone de contact (14) du composant (10), est détournée de celui-ci et s'étend à proximité d'une zone périphérique du dépôt de brasure (18),
chauffer directement la brasure dans le dépôt de brasure (18) jusqu'à ce que la brasure soit liquéfiée et que les zones de contact (14, 24) à relier aient atteint une température nécessaire pour effectuer le brasage, et
refroidir la liaison au moins jusqu'à solidification de la brasure.

6. Procédé selon la revendication 5,
**caractérisé en ce que** la zone de contact (14) du composant (10) est réchauffée au moins à proximité de la zone de bordure cintrée (28) avant le chauffage de la brasure jusqu'à une température au-dessous de la température de brasage.

7. Procédé selon la revendication 5 ou 6,
**caractérisé en ce que** le conducteur plat (20) est réchauffé dans la zone de la zone de bordure cintrée (28) avant le chauffage de la brasure jusqu'à une température au-dessous de la température de brasage.

8. Procédé selon l'une des revendications 5 à 7,
**caractérisé en ce que** la brasure est chauffée sans contact.

9. Procédé selon l'une des revendications 5 à 8,
**caractérisé en ce que** le chauffage de la brasure a lieu au moyen d'un courant gazeux protecteur chaud.

10. Procédé selon l'une des revendications 5 à 9,
**caractérisé en ce que**, après le positionnement, la zone de contact (14) du composant (10) et le conducteur plat (20) sont pressés l'une contre l'autre.
